# EUROPÄISCHE PATENTSCHRIFT

(11) **EP 3 939 395 B1**
(45) Veröffentlichungstag und Bekanntmachung des Hinweises auf die Patenterteilung: **02.08.2023**
(21) Anmeldenummer: 20706381.9
(22) Anmeldetag: 18.02.2020
(51) Int. Cl.: H05K 7/14, H01R 31/02, H01R 4/34, H01R 11/07

(54) **ANTRIEBSSYSTEM MIT EINEM ERSTEN MODUL**
DRIVE SYSTEM COMPRISING A FIRST MODULE
SYSTÈME D'ENTRAÎNEMENT COMPRENANT UN PREMIER MODULE

(30) Priorität: 12.03.2019 DE 102019001708
(43) Veröffentlichungstag der Anmeldung: 19.01.2022
(73) Patentinhaber: SEW-EURODRIVE GmbH & Co. KG, 76646 Bruchsal (DE)
(72) Erfinder: OTT, Jürgen, 76706 Dettenheim (DE); MÖHRING, Jens, 76703 Kraichtal (DE); KOLBERT, Alexander, 76356 Weingarten (DE)
(86) Internationale Anmeldenummer: PCT/EP2020/025076
(87) Internationale Veröffentlichungsnummer: WO 2020/182343

(56) Entgegenhaltungen:
- DE-A1-102016 012 093

## Beschreibung

Die Erfindung betrifft ein Antriebssystem mit einem ersten Modul.

Es ist allgemein bekannt, dass ein elektrisches Antriebssystem Stromzuführungen aufweist.

**Aus der** DE 10 2016 012093 A1 **ist als nächstliegender Stand der Technik ist eine Anschlusseinheit für ein Elektrogerät bekannt.**

Der Erfindung liegt daher die Aufgabe zugrunde, eine Stromzuführung mit hoher Sicherheit bereit zu stellen.

Erfindungsgemäß wird die Aufgabe bei dem Antriebssystem nach den in Anspruch 1 angegebenen Merkmalen gelöst.

Wichtige Merkmale der Erfindung bei dem Antriebssystem mit einem ersten Modul, insbesondere Versorgungsmodul oder Achsmodul, sind, dass auf einem als Gehäuseteil fungierenden Blechteil des ersten Moduls ein Isolierteil angeordnet ist, in welchem eine metallische Gewindebuchse stoffschlüssig, insbesondere mit Kunststoffmaterial umspritzt, verbunden und/oder angeordnet ist,

wobei eine Stromschiene zumindest teilweise in einer länglichen Vertiefung, insbesondere Nut, des Isolierteils aufgenommen ist,
wobei auf der vom Isolierteil abgewandten Seite der Stromschiene ein Stromschienenwinkel auf der Stromschiene aufgelegt und angeordnet ist,
wobei eine Schraube, insbesondere ein Schraubenkopf der Schraube, insbesondere über eine Unterlegscheibe, das Stromschienenwinkelteil an die Stromschiene andrückt und diese somit an das Isolierteil angedrückt wird,
wobei ein mit einem Kabel verbundener Kabelschuh mittels einer weiteren Schraube an das Stromschienenwinkelteil angeschraubt ist.

Von Vorteil ist dabei, dass mittels der Schraube das Stromschienenwinkelteil an die Stromschiene angedrückt wird. Da die Wandstärken dieser beiden Teile gleich sind, ist eine hohe Anpresskraft erlaubt und somit eine sichere Verbindung durch die Schraube bereit stellbar. Im Gegensatz dazu würde ein Auflegen eines Kabelschuhs zu einer unsicheren Verbindung führen, da die Wandstärke des Kabelschuhs äußerst gering ist, insbesondere kleiner als die Wandstärke der Stromschiene. Daher wäre nur eine geringere Anpresskraft durch die Schraube zulässig und somit die Verbindung nicht sicher gewährleistbar.

Die Stromschienen liegen flächig aufeinander und werden mit einer speziellen Schraube und Schraubverbindung fixiert. Der hiermit elektrisch zu verbindende Kabelschuh und das vom Kebalschuh aufgenommene Kabel sind in verschiedenen Varianten und Modifizierungen ausführbar.

Mit dem erfindugnsgemäßen Stromschienenwinkelteil wird eine definierte Auflage zur Stromschinen hin und zum Stomschienenwinkelteil und zur Schraube hin bereitstellbar.

Kontaktprobleme und somit Brandgefahr sind dadaurch vermeidbar, weil die Schnittstelle zwischen Stromschienenwinkelteil und Stromschiene definiert ausführbar ist und der Kabelschuh kann in seiner Wandstärkeund in seiner Form entsprechend variiert werden, insbesondere auch mit geringerem Kabelquerschnitt ausgeführt werden, insbesondere im Verglecih zur Strromschiene, und mit einer entsprechend kleinen Kabelschuhöffnung. Erfindugnsgemäß ist also ein flächiger Andruck der Schraubung auf die Stromschienen gewährleistbar und Kontaktproblemen sowie Abbrand der gesamten Verschraubung verhinderbar.

Da der Kabelschuh erfindungsgemäß an dem Stromschienenwinkelteil angeschraubt ist, hat dieser Kabelschuh des abgehenden Kabels keinen Einfluss auf die eigentliche Schraubverbindung
der Stromschienen.

Erfindungsgemäß wird der Kabelschuh an das Stromschienenwinkelteil angeschraubt, wobei die Verbindungsstelle beabstandet ist von dem berührberiech zwischen Stromschiene und Stromschienenwinkelteil. Auf diese Weise sind die verschieden starken mechanischen Andruckkräfte jeweiligen Schrauben, also der ersten Schraube und der weiteren Schraube, separiert, insbesondere und daher beide zum sicheren Betrieb dimensionierbar.

Außerdem ist durch die von der Stromschienen entfernte Verbindungsstelle zwischen Kabelschuh und Stromschienenwinkelteil das Kabel in vier verschiedene Raumrichtungen abführbar.

**Erfindungsgemäß** ist mittels zweier gegenläufig rechtwinkligen Biegestellen ein Teilbereich des Stromschienenwinkelteils parallel zur Stromschiene ausgerichtet und beabstandet von der Stromschiene,
wobei mittels der weiteren Schraube der Kabelschuh an den Teilbereich auf der von der Stromschiene abgewandten Seite des Teilbereichs schraubverbunden ist angeschraubt. Von Vorteil ist dabei, dass die Verbindungsstelle des Kabelschuhs höher, also weiter entfernt von der Stromschiene, ist. Somit ist ein Ausrichten des Kabelschuhs in verschiedene Raumrichtungen ermöglicht, die in einer Ebene liegen, deren Normalenrichtung parallel zur Schraubachse der Schraube ausgerichtet ist.

Bei einer vorteilhaften Ausgestaltung ist das Kabel mittels des Kabelschuhs elektrisch verbunden mit dem Stromschienenwinkelteil und somit mit der Gewindebuchse, welche mit der elektronischen Schaltung des ersten Moduls verbunden. Von Vorteil ist dabei, dass Somit die Stromschiene das obere Potential des gleichstromseitigen Anschlusses von Modulen verbindbar macht und mittel der Gewindebuchse eine elektrische Abzweigung des Potentials in das erste Modul hineinführbar ist zur Versorgung der elektronischen Schaltung des ersten Moduls. Außerdem ist eine weitere Abzweigung mittels des Stromschienenwinkelteils und des Kabelschuhs bewirkbar, so dass eine Schaltung mit geringerer Stromstärke als der in der Stromschiene durchgeleiteten Stromstärke versorgbar ist.

Bei einer vorteilhaften Ausgestaltung sind die Seitenränder der Vertiefung, insbesondere Nutwände, höher als die doppelte Wandstärke der Stromschiene,
wobei die Wandstärke der Stromschienen der Wandstärke des Stromschienenwinkelteils gleicht. Von Vorteil ist dabei, dass die Schraube eine hohe Anpresskraft bewirken darf und somit die elektrische Verbindung gesichert ist.

Bei einer vorteilhaften Ausgestaltung weist das Stromschienenwinkelteil auf der von der Stromschiene abgewandten Seite Erhebungen auf,
insbesondere wobei die Höhe der Erhebungen jeweils größer ist als die Wandstärke des Kabelschuhs im von der weiteren Schraube berührten Bereichs des Kabelschuhs,

insbesondere wobei die Erhebungen an den Ecken eines gedachten Quadrats derart angeordnet sind, dass zumindest zwei Erhebungen den Kabelschuh gegen Verdrehung formschlüssig sichern, insbesondere deren Drehachse parallel zur Schraubenachse der weiteren Schraube ist. Von Vorteil ist dabei, dass eine Verdrehsicherung für den Kabelschuh in einfacher Weise gewährleistbar ist.

Bei einer vorteilhaften Ausgestaltung ist der Kabelschuh ein aus Metallblech gefertigtes Stanz-Biegeteil. Von Vorteil ist dabei, dass eine einfache und kostengünstige Herstellung ermöglicht ist.

Bei einer vorteilhaften Ausgestaltung wird aus dem Kabel eine als Bremssteueranordnung fungierende Signalelektronik versorgt,
wobei die im Kabel durchgeleitete Stromstärke mehr als zehnmal kleiner ist als die durch die Stromschiene durchgeleitete Stromstärke. Von Vorteil ist dabei, dass ein Verbraucher mit Strom aus dem oberen Potential versorgbar ist, wobei der maximal vom Verbraucher entnommene Strom mindestens zehnmal kleiner ist als der durch die Stromschiene durchgeleitete Strom.

Bei einer vorteilhaften Ausgestaltung weist das Antriebssystem ein zweites Modul, insbesondere Versorgungsmodul oder Achsmodul, auf, welches mittels der Stromschiene mit dem ersten Modul elektrisch verbunden ist,
wobei auf einem als Gehäuseteil fungierenden Blechteil des zweiten Moduls ein zweites Isolierteil angeordnet ist, in welchem eine zweite metallische Gewindebuchse stoffschlüssig, insbesondere mit Kunststoffmaterial umspritzt, verbunden und/oder angeordnet ist,
wobei die Stromschiene zumindest teilweise in einer länglichen Vertiefung, insbesondere Nut, des zweiten Isolierteils aufgenommen ist,
wobei auf der vom zweiten Isolierteil abgewandten Seite der Stromschiene ein zweiter Stromschienenwinkel auf der Stromschiene aufgelegt und angeordnet ist,
wobei eine zweite Schraube, insbesondere ein Schraubenkopf der Schraube, insbesondere über eine zweite Unterlegscheibe, das zweite Stromschienenwinkelteil an die Stromschiene andrückt und diese somit an das zweite Isolierteil angedrückt wird,
wobei ein mit einem zweiten Kabel verbundener zweiter Kabelschuh mittels einer weiteren zweiten Schraube an das zweite Stromschienenwinkelteil angeschraubt ist. Von Vorteil ist dabei, dass ein zweites Modul in derselben Weise und mit denselben Vorteilen mit dem in der Stromschiene geführte oberen Potential verbindbar ist.

Bei einer vorteilhaften Ausgestaltung ist mittels zweier gegenläufig rechtwinkligen Biegestellen ein Teilbereich des zweiten Stromschienenwinkelteils parallel zur Stromschiene ausgerichtet und beabstandet von der Stromschiene,
wobei mittels der weiteren zweiten Schraube der zweite Kabelschuh an den Teilbereich des zweiten Stromschienenwinkelteils auf der von der Stromschiene abgewandten Seite des Teilbereichs des zweiten Stromschienenwinkelteils schraubverbunden ist. Von Vorteil ist dabei, dass wiederum eine Beabstandung der Verbindungsstelle des Kabelschuhs erreichbar ist und somit ein Abgehen des zweiten Kabels in verschiedene Raumrichtungen ermöglicht ist.

Bei einer vorteilhaften Ausgestaltung ist das zweite Kabel mittels des zweiten Kabelschuhs elektrisch verbunden mit dem zweiten Stromschienenwinkelteil und somit mit der zweiten Gewindebuchse, welche mit der elektronischen Schaltung des zweiten Moduls verbunden ist. Von Vorteil ist dabei, dass eine Abzweigung des oberen Potentials auch zum zweiten Modul hin erreichbar ist.

Bei einer vorteilhaften Ausgestaltung weist das erste Modul einen Wechselrichter auf, aus dessen wechselspannungsseitigem Anschluss ein Elektromotor gespeist wird und dessen oberes Potential seines gleichspannungsseitigen Anschlusses über die Stromschiene bereitgestellt wird. Von Vorteil ist dabei, dass das erste Modul als Achsmodul ausführbar ist. Bei einer vorteilhaften Ausgestaltung weist das zweite Modul einen netzgespeisten Gleichrichter auf, dessen oberes Potential seines gleichspannungsseitigen Anschlusses mit der Stromschiene verbunden ist. Von Vorteil ist dabei, dass das zweite Moduls als Versorgungsmodul ausführbar ist, welches über die Stromschiene ein Zwischenkreispotential dem Achsmodul zur Verfügung stellt.

Bei einer vorteilhaften Ausgestaltung ist ein Haubenteil zur Abdeckung der Stromschiene mittels eines Schraubteils am Isolierteil befestigt, wobei das Schraubteil in eine Verdickung einer der Seitenwände, insbesondere Nutwände, des Isolierteils eingeschraubt ist. Von Vorteil ist dabei, dass die Stromschiene sicher gegen Berührung abdeckbar ist und das isolierteil genügend fest mit dem Gehäuseteil des Moduls verbunden ist, so dass die Haube befestigbar ist und durch das isolierteil haltbar ist.

Weitere Vorteile ergeben sich aus den Unteransprüchen.

Die Erfindung wird nun anhand von schematischen Abbildungen näher erläutert:
In der Figur 1 ist ein erfindungsgemäßes Antriebssystem mit einem Achsmodul und einem Versorgungsmodul 7, welches dem Achsmodul 8 eine Gleichspannung mittels Stromschienen 1 zur Verfügung stellt.
In der Figur 2 weisen ein Versorgungsmodul 20 und ein Achsmodul 21 jeweils eine größere Baugröße auf.
In der Figur 3 ist ein vergrößerter Ausschnitt der Zwischenkreisverbindung der beiden Module (20, 21) mit Stromschienen dargestellt.
In der Figur 4 ist ein Ausschnitt der Figur 3 in Schrägansicht dargestellt.

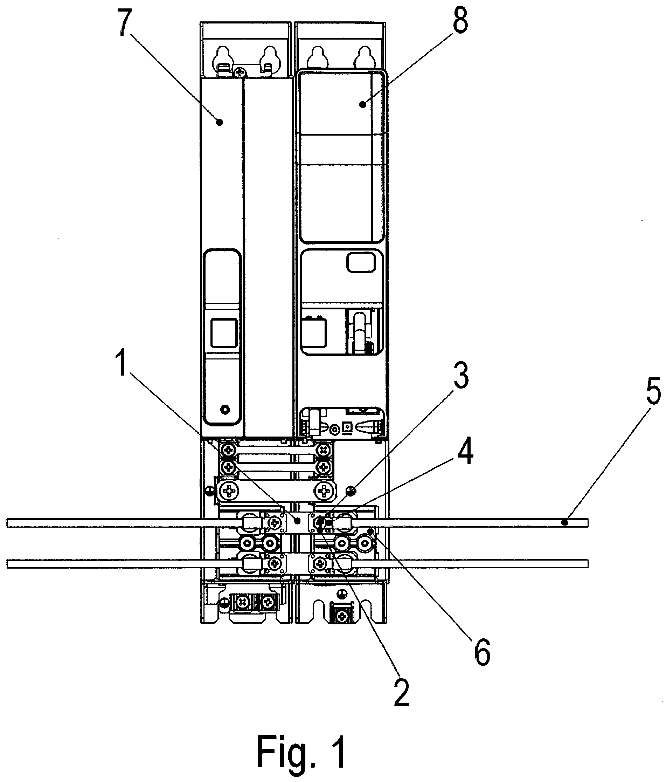

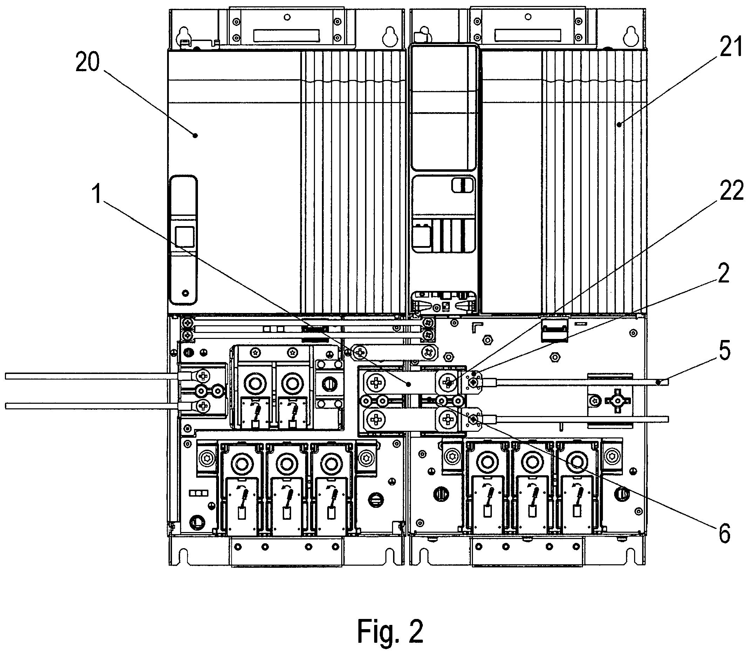

Figur 1 zeigt also ein kleineres Versorgungsmodul 7 und ein kleineres Achsmodul 8 im Vergleich zur Figur 2.

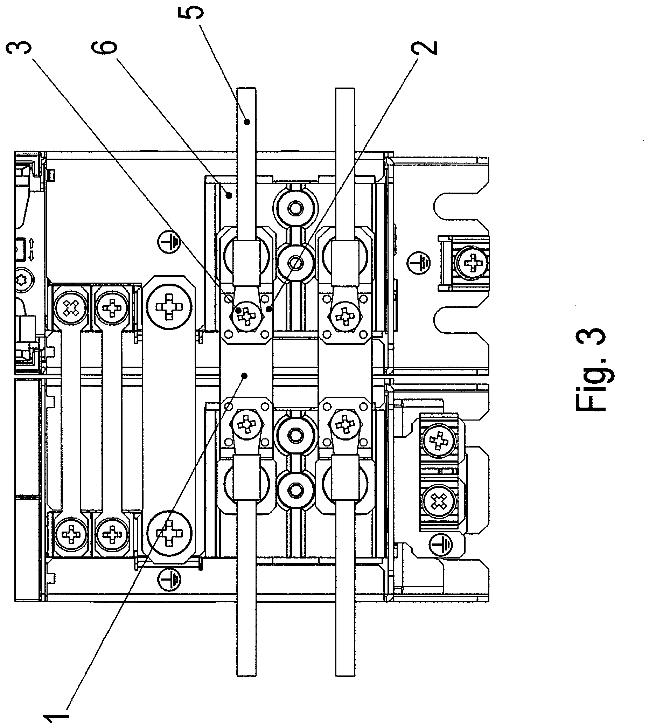

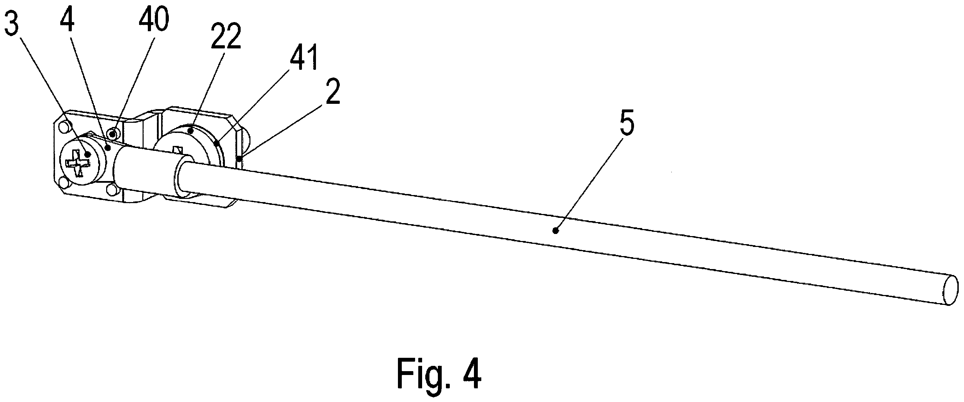

Wie in den Figuren 2 bis 4 dargestellt, weist das Versorgungsmodul 20 einen Gleichspannungsausgang auf, an welchem es ein oberes Potential und ein unteres Potential zur Verfügung stellt.

Das Versorgungsmodul ist aus einem Wechselspannungsversorgungsnetz mit Drehstrom versorgbar und umfasst einen Gleichrichter, dessen gleichsspannungsseitiger Anschluss somit als Gleichspannungsausgang aus dem Versorgungsmodul 20 herausgeführt ist.

Das Achsmodul 21 umfasst einen Wechselrichter, aus dessen wechselspannungsseitigem Ausgang ein Elektromotor versorgbar ist und dessen gleichspannungsseitiger Eingang mit dem Gleichspannungsausgang des Versorgungsmoduls 20 mittels Stromschienen 1 verbunden ist.

Die Verwendung von Stromschienen 1 ermöglicht das Durchleiten von Starkstrom, insbesondere also hohen Strömen.

Die zur Durchleitung des oberen Potentials vorgesehene Stromschiene 1 ist in einer Nut eines Isolierteils 6 des Achsmoduls 21 eingelegt und weist eine Ausnehmung auf, durch welche eine Schraube 22 geführt ist. Mit ihrem Gewindeabschnitt ist die Schraube 22 in eine Gewindebohrung einer metallischen Hülse eingeschraubt, welche im Isolierstück 6 stoffschlüssig, insbesondere also mit Kunststoffmaterial des Isolierstücks 6 umspritzt, verbunden ist.

Ein Stromschienenwinkelteil 2 weist zwei gegenläufig rechtwinklige Biegestellen auf. Die Schraube 22 ist auch durch eine Ausnehmung des Stromschienenwinkelteil 2 geführt, so beim Einschrauben des Gewindeabschnitts der Schraube 22 in die Gewindebohrung der metallischen Hülse der Schraubenkopf eine zwischen Schraubenkopf der Schraube 22 und Stromschienenwinkelteil 2 angeordnete Unterlegscheibe an das Stromschienenwinkelteil 2 andrückt und somit auch das Stromschienenwinkelteil 2 auf die Stromschiene 1 andrückt.

Mittels der beiden gegenläufig rechtwinkligen Biegestellen ist ein Teilbereich des Stromschienenwinkelteils 2 parallel zur Stromschiene 1 ausgerichtet und beabstandet von der Stromschiene 1.

Mittels einer Schraube 3 ist ein Kabelschuh 4 an den Teilbereich auf der von der Stromschienen 1 abgewandten Seite des Teilbereichs angeschraubt. Mittels des Kabelschuhs ist ein Kabel 5 elektrisch verbunden.

Somit ist mittels des Stromschienenwinkelteils 2 ermöglicht, dass die Schraube 22 mit großer Anpresskraft die Verbindung bis zur metallischen Hülse des Isolierteils 6 sichert. Der im Vergleich zum Stromschienenwinkelteil 2 und zur Stromschiene 1 dünnwandigere Kabelschuh 4 ist also nicht mit der Schraube 22 befestigt, sondern mit der Schraube 3, die eine viel kleinere Anpresskraft erzeugt.

Die Wandstärke des Stromschienenwinkelteils 2 ist vorzugsweise dieselbe wie die Wandstärke der Stromschiene 1.

Die metallische Hülse ist elektrisch verbunden mit der elektronischen Schaltung des Achsmoduls 21 und fungiert somit als Stromzuleitung für das Achsmodul 21.

An dem Teilberiech sind auf der von der Stromschiene 1 abgewandten Seite des Stromschienenwinkelteils 2 Erhebungen 40 angeordnet, welche den von der Schraube 3 an den Teilbereich angedrückten Kabelschuh 4 formschlüssig gegen Verdrehung, insbesondere innerhalb der zur Berührfläche zwischen Stromschienenwinkelteil 2 und Kabelschuh 4 parallelen Ebene, sichern. Dabei sind die Erhebungen 40 jeweils zueinander gleichartig ausgeformt und an den Ecken eines gedachten Quadrats angeordnet. Auf diese Weise ist der Kabelschuh 4 samt Kabel 5 in vier Richtungen herausführbar und dabei jeweils gesichert.

Die Wandstärke des Kabelschuhs 4 ist dabei kleiner als die Höhe der Erhebungen 40.

In gleicher Weise ist die Stromschiene 1 mit dem Versorgungsmodul 20 elektrisch kontaktiert und angebunden, insbesondere auch mittels Anbindung eines weiteren Kabels mittels eines weiteren Kabelschuhs an ein weiteres Stromschienenwinkelteil.

Entsprechend ist auch das untere Potential mittels einer weiteren Stromschiene mit den beiden Modulen (20, 21) verbunden.

Mittels der Kabel 5 ist somit eine als Bremssteueranordnung fungierende Signalelektronik versorgbar. Dabei benötigt diese Signalelektronik nur eine viel geringere Stromstärke als durch die Stromschiene 1 maximal durchleitbar ist. Insbesondere ist die durch das Kabel 5 durchgeleitete Stromstärke mehr als zehnmal kleiner als die durch die Stromschiene 1 durchgeleitete Stromstärke.

Die am Isolierteil 6 ausgebildete Nut, in welcher die Stromschiene 1 aufgenommen ist, weist Nutwände auf, welche zur formschlüssigen Verdrehsicherung der Stromschiene 1 selbst und des auf die Stromschiene 1 aufgelegten Stromschienenwinkelteils 2. Daher weist die Nut einen Nutwandbereich auf, dessen vom Nutboden aus, insbesondere in Richtung der Schraubachse der Schraube 22, gemessenen Höhe mehr als das Doppelte der Wandstärke der Stromschiene 1 beträgt.

Die beidseitig der Stromschiene 1 sich erhebenden Nutwände erhöhen auch die Kriechstrecken und somit die Sicherheit.

Das Isolierteil 6 wird von einer Schraube gegen ein als Gehäuseteil fungierendes Blechteil des Achsmoduls 21 gepresst.

Ein als Berührschutzfungierendes Haubenteil ist mit einem Schraubteil am Isolierteil befestigt, wobei das Schraubteil in das Isolierteil einschraubbar ist.

Die Stromschienen liegen flächig aufeinander und werden mit einer speziellen Schraube und Schraubverbindung fixiert. Der hiermit elektrisch zu verbindende Kabelschuh und das vom Kebalschuh aufgenommene Kabel sind in verschiedenen Varianten und Modifizierungen ausführbar.

Mit dem erfindugnsgemäßen Stromschienenwinkelteil wird eine definierte Auflage zur Stromschinen hin und zum Stomschienenwinkelteil und zur Schraube hin bereitstellbar.

Kontaktprobleme und somit Brandgefahr sind dadaurch vermeidbar, weil die Schnittstelle zwischen Stromschienenwinkelteil und Stromschiene definiert ausführbar ist und der Kabelschuh kann in seiner Wandstärkeund in seiner Form entsprechend variiert werden, insbesondere auch mit geringerem Kabelquerschnitt ausgeführt werden, insbesondere im Verglecih zur Strromschiene, und mit einer entsprechend kleinen Kabelschuhöffnung.

Erfindugnsgemäß ist also ein flächiger Andruck der Schraubung auf die Stromschienen gewährleistbar und Kontaktproblemen sowie Abbrand der gesamten Verschraubung verhinderbar.

Da der Kabelschuh erfindungsgemäß an dem Stromschienenwinkelteil angeschraubt ist, hat dieser Kabelschuh des abgehenden Kabels keinen Einfluss auf die eigentliche Schraubverbindung der Stromschienen.

### Bezugszeichenliste

1 Stromschiene
2 Stromschienenwinkelteil
3 Schraube
4 Kabelschuh
5 Kabel
6 Isolierteil
7 Versorgungsmodul
8 Achsmodul
20 Versorgungsmodul
21 Achsmodul
22 Schraube
40 Erhebung zur Verdrehsicherung
41 Unterlegscheibe

## Patentansprüche

1. Antriebssystem mit einem Ersten Modul, insbesondere Versorgungsmodul (7, 20) oder Achsmodul (8, 21),
**wobei** auf einem als Gehäuseteil fungierenden Blechteil des Ersten Moduls ein Isolierteil (6) angeordnet ist, in welchem eine metallische Gewindebuchse stoffschlüssig, insbesondere mit Kunststoffmaterial umspritzt, verbunden und/oder angeordnet ist,
wobei eine Stromschiene (1) zumindest teilweise in einer länglichen Vertiefung, insbesondere Nut, des Isolierteils (6) aufgenommen ist,
wobei auf der vom Isolierteil (6) abgewandten Seite der Stromschiene (1) ein Stromschienenwinkel auf der Stromschiene (1) aufgelegt und angeordnet ist,
wobei eine Schraube (3, 22), insbesondere ein Schraubenkopf der Schraube (3, 22), insbesondere über eine Unterlegscheibe (41), das Stromschienenwinkelteil (2) an die Stromschiene (1) andrückt und diese somit an das Isolierteil (6) angedrückt wird,
wobei ein mit einem Kabel (5) verbundener Kabelschuh (4) mittels einer weiteren Schraube (3, 22) an das Stromschienenwinkelteil (2) angeschraubt ist,
**dadurch gekennzeichnet, dass**
**mittels zweier gegenläufig rechtwinkligen Biegestellen ein Teilbereich des Stromschienenwinkelteils (2) parallel zur Stromschiene (1) ausgerichtet und beabstandet von der Stromschiene (1) ist,**
**wobei mittels der weiteren Schraube (3, 22) der Kabelschuh (4) an den Teilbereich auf der von der Stromschiene (1) abgewandten Seite des Teilbereichs schraubverbunden ist.**

2. Antriebssystem nach Anspruch 1,
**dadurch gekennzeichnet, dass**
das Kabel (5) mittels des Kabelschuhs (4) elektrisch verbunden ist mit dem Stromschienenwinkelteil (2) und somit mit der Gewindebuchse, welche mit der elektronischen Schaltung des ersten Moduls verbunden ist.

3. Antriebssystem nach Anspruch 1 oder 2,
**dadurch gekennzeichnet, dass**
die Seitenränder der Vertiefung, insbesondere Nutwände, höher sind als die doppelte Wandstärke der Stromschiene (1),
wobei die Wandstärke der Stromschienen (1) der Wandstärke des Stromschienenwinkelteils (2) gleicht.

4. Antriebssystem nach einem der vorangegangenen Ansprüche,
**dadurch gekennzeichnet, dass**
das Stromschienenwinkelteil (2) auf der von der Stromschiene (1) abgewandten Seite Erhebungen (40) aufweist,
insbesondere wobei die Höhe der Erhebungen (40) jeweils größer ist als die Wandstärke des Kabelschuhs (4) im von der weiteren Schraube (3, 22) berührten Bereichs des Kabelschuhs (4),
insbesondere wobei die Erhebungen (40) an den Ecken eines gedachten Quadrats derart angeordnet sind, dass zumindest zwei Erhebungen (40) den Kabelschuh (4) gegen Verdrehung formschlüssig sichern, insbesondere deren Drehachse parallel zur Schraubenachse der weiteren Schraube (3, 22) ist.

5. Antriebssystem nach einem der vorangegangenen Ansprüche,
**dadurch gekennzeichnet, dass**
der Kabelschuh (4) ein aus Metallblech gefertigtes Stanz-Biegeteil ist.

6. Antriebssystem nach einem der vorangegangenen Ansprüche,
**dadurch gekennzeichnet, dass**
aus dem Kabel (5) eine als Bremssteueranordnung fungierende Signalelektronik versorgt wird,
wobei die im Kabel (5) durchgeleitete Stromstärke mehr als zehnmal kleiner ist als die durch die Stromschiene (1) durchgeleitete Stromstärke.

7. Antriebssystem nach einem der vorangegangenen Ansprüche, wobei
das Antriebssystem ein zweites Modul, insbesondere Versorgungsmodul (7, 20) oder Achsmodul (8, 21), aufweist, welches mittels der Stromschiene (1) mit dem ersten Modul elektrisch verbunden ist,
**dadurch gekennzeichnet, dass**
auf einem als Gehäuseteil fungierenden Blechteil des zweiten Moduls ein zweites Isolierteil (6) angeordnet ist, in welchem eine zweite metallische Gewindebuchse stoffschlüssig, insbesondere mit Kunststoffmaterial umspritzt, verbunden und/oder angeordnet ist,
wobei die Stromschiene (1) zumindest teilweise in einer länglichen Vertiefung, insbesondere Nut, des zweiten Isolierteils (6) aufgenommen ist,
wobei auf der vom zweiten Isolierteil (6) abgewandten Seite der Stromschiene (1) ein zweiter Stromschienenwinkel auf der Stromschiene (1) aufgelegt und angeordnet ist,
wobei eine zweite Schraube (3, 22), insbesondere ein Schraubenkopf der Schraube (3, 22), insbesondere über eine zweite Unterlegscheibe (41), das zweite Stromschienenwinkelteil (2) an die Stromschiene (1) andrückt und diese somit an das zweite Isolierteil (6) angedrückt wird,
wobei ein mit einem zweiten Kabel (5) verbundener zweiter Kabelschuh (4) mittels einer weiteren zweiten Schraube (3, 22) an das zweite Stromschienenwinkelteil (2) angeschraubt ist.

8. Antriebssystem nach einem der vorangegangenen Ansprüche,
**dadurch gekennzeichnet, dass**
mittels zweier gegenläufig rechtwinkligen Biegestellen ein Teilbereich des zweiten Stromschienenwinkelteils (2) parallel zur Stromschiene (1) ausgerichtet und beabstandet von der Stromschiene (1) ist,
wobei mittels der weiteren zweiten Schraube (3, 22) der zweite Kabelschuh (4) an den Teilbereich des zweiten Stromschienenwinkelteils (2) auf der von der Stromschiene (1) abgewandten Seite des Teilbereichs des zweiten Stromschienenwinkelteils (2) schraubverbunden ist.

9. Antriebssystem nach einem der vorangegangenen Ansprüche,
**dadurch gekennzeichnet, dass**
das zweite Kabel (5) mittels des zweiten Kabelschuhs (4) elektrisch verbunden ist mit dem zweiten Stromschienenwinkelteil (2) und somit mit der zweiten Gewindebuchse, welche mit der elektronischen Schaltung des zweiten Moduls verbunden ist.

10. Antriebssystem nach einem der vorangegangenen Ansprüche,
**dadurch gekennzeichnet, dass**
das erste Modul einen Wechselrichter aufweist, aus dessen wechselspannungsseitigem Anschluss ein Elektromotor gespeist wird und dessen oberes Potential seines gleichspannungsseitigen Anschlusses über die Stromschiene (1) bereitgestellt wird.

11. Antriebssystem nach einem der vorangegangenen Ansprüche,
**dadurch gekennzeichnet, dass**
das zweite Modul einen netzgespeisten Gleichrichter aufweist, dessen oberes Potential seines gleichspannungsseitigen Anschlusses mit der Stromschiene (1) verbunden ist.

12. Antriebssystem nach einem der vorangegangenen Ansprüche,
**dadurch gekennzeichnet, dass**
ein Haubenteil zur Abdeckung der Stromschiene (1) mittels eines Schraubteils am Isolierteil (6) befestigt ist, wobei das Schraubteil in eine Verdickung einer der Seitenwände, insbesondere Nutwände, des Isolierteils (6) eingeschraubt ist.

## Claims

1. Drive system comprising a first module, in particular a power supply module (7, 20) or axis module (8, 21),
wherein an insulating part (6) is arranged on a sheet-metal part of the first module that functions as a housing part, in which insulating part a metal threaded bushing is connected and/or arranged in a cohesive manner, in particular in a manner encapsulated by injection moulding with plastic,
wherein a busbar (1) is received at least partially in an elongate recess, in particular a groove, of the insulating part (6),
wherein a busbar bracket is placed and arranged on the busbar (1) on the side of the busbar (1) facing away from the insulating part (6),
wherein a screw (3, 22), in particular a screw head of the screw (3, 22), presses the busbar bracket part (2) against the busbar (1), in particular via a washer (41), and the busbar is thus pressed against the insulating part (6),
wherein a cable shoe (4), which is connected to a cable (5), is screwed onto the busbar bracket part (2) by means of a further srew(3, 22),
**characterized in that**,
by means of two oppositely right-angled bends, a sub-region of the busbar bracket part (2) is oriented parallel to the busbar (1) and is arranged at a distance from the busbar (1),
wherein, by means of the further screw (3, 22), the cable shoe (4) is screw-connected to the sub-region on the side of the sub-region facing away from the busbar (1).

2. Drive system according to claim 1,
**characterized in that**,
by means of the cable shoe (4), the cable (5) is electrically connected to the busbar bracket part (2) and thus to the threaded bushing, which is connected to the electronic circuit of the first module.

3. Drive system according to claim 1 or 2,
**characterized in that**
the side edges of the recess, in particular groove walls, are higher than twice the wall thickness of the busbar (1),
wherein the wall thickness of the busbars (1) is equal to the wall thickness of the busbar bracket part (2).

4. Drive system according to any one of the preceding claims, **characterized in that**
the busbar bracket part (2) has elevations (40) on the side facing away from the busbar (1),
in particular wherein the height of the elevations (40) is in each case greater than the wall thickness of the cable shoe (4) in the region of the cable shoe (4) at which the further screw (3, 22) makes contact,
in particular wherein the elevations (40) are arranged at the corners of an imaginary square such that at least two elevations (40), by way of a form fit, secure the cable shoe against rotation, in particular the axis of rotation of which is parallel to the screw axis of the further screw (3, 22).

5. Drive system according to any one of the preceding claims, **characterized in that**
the cable shoe (4) is a stamped and bent part manufactured from sheet metal.

6. Drive system according to any one of the preceding claims, **characterized in that**
signal electronics that function as a brake control arrangement are supplied with power from the cable (5),
wherein the current strength conducted through the cable (5) is more than ten times lower than the current strength conducted through the busbar (1).

7. Drive system according to any one of the preceding claims,
wherein the drive system comprises a second module, in particular a power supply module (7, 20) or axis module (8, 21), which is electrically connected to the first module by means of the busbar (1),
**characterized in that**
a second insulating part (6) is arranged on a sheet-metal part of the second module that functions as a housing part, in which second insulating part a second metal threaded bushing is connected and/or arranged in a cohesive manner, in particular in a manner encapsulated by injection moulding with plastic,
wherein the busbar (1) is received at least partially in an elongate recess, in particular a groove, of the second insulating part (6),
wherein a second busbar bracket is placed and arranged on the busbar (1) on the side of the busbar (1) facing away from the second insulating part (6),
wherein a second screw (3, 22), in particular a screw head of the screw (3, 22), presses the second busbar bracket part (2) against the busbar (1), in particular via a second washer (41), and the busbar is thus pressed against the second insulating part (6),
wherein a second cable shoe (4), which is connected to a second cable (5), is screwed onto the second busbar bracket part (2) by means of a further second screw (3, 22).

8. Drive system according to any one of the preceding claims, **characterized in that**,
by means of two oppositely right-angled bends, a sub-region of the second busbar bracket part (2) is oriented parallel to the busbar (1) and is arranged at a distance from the busbar (1),
wherein, by means of the further second screw (3, 22), the second cable shoe (4) is screw-connected to the sub-region of the second busbar bracket part (2) on the side of the sub-region of the second busbar bracket part (2) facing away from the busbar (1).

9. Drive system according to any one of the preceding claims, **characterized in that**,
by means of the second cable shoe (4), the second cable (5) is electrically connected to the second busbar bracket part (2) and thus to the second threaded bushing, which is connected to the electronic circuit of the second module.

10. Drive system according to any one of the preceding claims, **characterized in that**
the first module comprises an inverter, the AC-side connection of which powers an electric motor, and the upper potential of the DC-side connection of which is made available via the busbar (1) .

11. Drive system according to any one of the preceding claims, **characterized in that**
the second module comprises a mains-powered rectifier, the upper potential of the DC-side connection of which is connected to the busbar (1).

12. Drive system according to any one of the preceding claims, **characterized in that**
a hood part for covering the busbar (1) is fastened to the insulating part (6) by means of a screw part, wherein the screw part is screwed into a thickened portion of one of the side walls, in particular groove walls, of the insulating part (6).

## Revendications

1. Système d'entraînement comprenant un premier module, en particulier un module d'alimentation (7, 20) ou un module d'axe (8, 21),
une partie isolante (6) étant agencée sur une partie en tôle du premier module faisant office de partie de boîtier, dans laquelle une douille filetée métallique est reliée et/ou agencée par une liaison de matière, en particulier moulée par injection de matière plastique,
une barre conductrice (1) étant reçue au moins partiellement dans un évidement longitudinal, en particulier une rainure, de la partie isolante (6),
une cornière de barre conductrice étant placée et agencée sur la barre conductrice (1) du côté de la barre conductrice (1) opposé à la partie isolante (6),
une vis (3, 22), en particulier une tête de la vis (3, 22), pressant la cornière de barre conductrice, en particulier par l'intermédiaire d'une rondelle (41), sur la barre conductrice (1) et celle-ci est plaquée sur la partie isolante (6),
une cosse de câble (4) reliée à un câble (5) étant vissée sur la partie de cornière de barre conductrice (2) au moyen d'une vis supplémentaire (3, 22),
**caractérisé en ce que**
une zone partielle de la partie de cornière de barre conductrice (2) est orientée parallèlement à la barre conductrice (1) et à distance de la barre conductrice (1) au moyen de deux points de flexion perpendiculaires opposés,
la cosse de câble (4) étant reliée par vissage à la zone partielle sur le côté de la zone partielle opposé la barre conductrice (1) au moyen de la vis supplémentaire (3, 22).

2. Système d'entraînement selon la revendication 1,
**caractérisé en ce que**
le câble (5) est relié électriquement à la partie de cornière de barre conductrice (2) au moyen de la cosse de câble (4) et donc à la douille filetée qui est reliée au circuit électronique du premier module.

3. Système d'entraînement selon la revendication 1 ou 2,
**caractérisé en ce que**
les bords latéraux de l'évidement allongé, en particulier les parois de la rainure, sont plus hauts que le double de l'épaisseur de paroi de la barre conductrice (1),
l'épaisseur de paroi des rails conducteurs (1) étant égale à l'épaisseur de paroi de la partie de cornière de barre conductrice (2).

4. Système d'entraînement selon l'une quelconque des revendications précédentes, **caractérisé en ce que**
la partie de cornière de barre conductrice (2) présente des saillies (40) sur le côté opposé à la barre conductrice (1),
la hauteur des saillies (40) étant en particulier respectivement supérieure à l'épaisseur de paroi de la cosse de câble (4) dans la zone de la cosse de câble (4) en contact avec la vis supplémentaire (3, 22),
les saillies (40) étant en particulier agencées aux coins d'un carré imaginaire de telle sorte qu'au moins deux saillies (40) bloquent la cosse de câble (4) par complémentarité de formes à l'encontre d'une rotation, leur axe de rotation étant en particulier parallèle à l'axe de vis de la vis supplémentaire (3, 22).

5. Système d'entraînement selon l'une quelconque des revendications précédentes, **caractérisé en ce que**
la cosse de câble (4) est une pièce pliée estampée fabriquée en tôle métallique.

6. Système d'entraînement selon l'une quelconque des revendications précédentes, **caractérisé en ce que**
une électronique de signal servant de dispositif de commande de frein est alimentée à partir du câble (5),
l'intensité du courant traversant le câble (5) étant plus de dix fois plus petite que l'intensité du courant traversant la barre conductrice (1).

7. Système d'entraînement selon l'une quelconque des revendications précédentes,
le système d'entraînement présente un second module, en particulier un module d'alimentation (7, 20) ou un module d'axe (8, 21), qui est connecté électriquement au premier module au moyen de la barre conductrice (1),
**caractérisé en ce que**
une seconde partie isolante (6) est disposée sur une partie de tôle du second module faisant office de partie de boîtier, dans laquelle une seconde douille filetée métallique est surmoulée, reliée et/ou agencée par une liaison de matière, en particulier avec une matière plastique,
la barre conductrice (1) étant logée au moins partiellement dans un évidement oblong, en particulier une rainure, de la seconde partie isolante (6),
une seconde cornière de barre conductrice étant appliquée sur la barre conductrice (1) et agencée sur le côté de la barre conductrice (1) opposé à la seconde partie isolante (6),
une seconde vis (3, 22), en particulier une tête de vis de la vis (3, 22), pressant la seconde partie de cornière de barre conductrice (2), en particulier par l'intermédiaire d'une seconde rondelle (41), sur la barre conductrice (1) et étant ainsi pressée sur la seconde partie isolante (6),
une seconde cosse de câble (4) reliée à un second câble (5) étant vissée sur la seconde partie de cornière de barre conductrice (2) au moyen d'une seconde vis supplémentaire (3, 22).

8. Système d'entraînement selon l'une quelconque des revendications précédentes, **caractérisé en ce que**
une zone partielle de la seconde partie de cornière de barre conductrice (2) est orientée parallèlement à la barre conductrice (1) et à distance de la barre conductrice (1) au moyen de deux points de flexion perpendiculaires opposés,
au moyen de la seconde vis (3, 22), la seconde cosse de câble (4) étant reliée par vissage à la zone partielle de la seconde partie de cornière de barre conductrice (2) sur le côté de la zone partielle de la seconde partie de cornière de barre conductrice (2) opposé à la barre conductrice (1).

9. Système d'entraînement selon l'une quelconque des revendications précédentes, **caractérisé en ce que**
le second câble (5) est relié électriquement à la seconde partie de cornière de barre conductrice (2) au moyen de la seconde cosse de câble (4) et donc à la seconde douille filetée qui reliée au circuit électronique du second module.

10. Système d'entraînement selon l'une quelconque des revendications précédentes, **caractérisé en ce que**
le premier module présente un onduleur, à partir de la liaison côté tension alternative duquel un moteur électrique est alimenté et dont le potentiel supérieur de sa liaison côté tension continue est fourni par l'intermédiaire de la barre conductrice (1).

11. Système d'entraînement selon l'une quelconque des revendications précédentes, **caractérisé en ce que**
le second module présente un redresseur alimenté par le secteur, dont le potentiel supérieur de sa liaison côté tension continue est relié à la barre conductrice (1).

12. Système d'entraînement selon l'une quelconque des revendications précédentes, **caractérisé en ce que**
une partie de capot pour recouvrir la barre conductrice (1) est fixée à la partie isolante (6) au moyen d'une partie vissée, la partie vissée étant vissée dans un épaississement d'une des parois latérales, en particulier des parois de rainure, de la partie isolante (6).
